# EUROPEAN PATENT APPLICATION

(11) **EP 4 383 336 A1**
(43) Date of publication of application: **12.06.2024**
(21) Application number: 21956140.4
(22) Date of filing: 06.09.2021
(51) Int. Cl.: H01L 27/15, H01L 33/48, H01L 33/62, H01L 25/075

(54) **DISPLAY DEVICE**

(71) Applicant: LG Electronics Inc., Yeongdeungpo-gu Seoul 07336 (KR); LG Display Co., Ltd., Seoul 07336 (KR)
(72) Inventor: KO, Jisoo, Seoul 06772 (KR); LEE, Minwoo, Seoul 06772 (KR); MOON, Seongmin, Seoul 06772 (KR); SUNG, Junho, Seoul 06772 (KR)
(74) Representative: Vossius & Partner Patentanwälte Rechtsanwälte mbB
(86) International application number: PCT/KR2021/012005
(87) International publication number: WO 2023/033212

(57) **Abstract**

The display device may include a substrate having a plurality of assembly areas and non-assembly areas, a first partition arranged on a plurality of assembly areas and having an assembly hole, a second partition disposed on the non-assembly areas and a semiconductor light emitting device in the assembly hole, wherein a thickness of the second partition is greater than the thickness of the first partition.

## Description

### Technical field

The embodiment relates to a display device.

### Background Art

Display devices display high-definition images using self-luminous devices such as light emitting diodes as light sources for pixels. Light emitting diodes exhibit excellent durability even under harsh environmental conditions and are capable of long lifespan and high brightness, so they are attracting attention as a light source for next-generation display devices.

Recently, research is underway to manufacture ultra-small light emitting diodes using highly reliable inorganic crystal structure materials and place them on panels of display devices (hereinafter referred to as "display panels") to use them as next-generation light sources.

These display devices are expanding beyond flat displays into various forms such as flexible displays, foldable displays, stretchable displays, and rollable displays.

In order to realize high resolution, the size of pixels is gradually becoming smaller, and since the light emitting device must be aligned with numerous pixels of such a small size, research on the manufacture of ultra-small light emitting diodes as small as micro or nano scale is being actively conducted.

Display devices typically contain tens of millions of pixels or more. Accordingly, because it is very difficult to align at least one light-emitting element in each of tens of millions of small pixels, various studies on ways to align light-emitting elements in a display panel are being actively conducted.

As the size of light-emitting devices becomes smaller, quickly and accurately transferring these light-emitting devices onto the substrate is becoming a very important problem to solve. Transfer technologies that have been recently developed include the pick and place process, laser lift-off method, or self-assembly method. In particular, the self-assembly method of transferring a light-emitting device onto a substrate using a magnetic material (or magnet) has recently been in the spotlight.

In the self-assembly method, numerous light emitting devices are dropped into the mold containing the fluid, and as the magnetic material moves, the light emitting devices dropped into the fluid are moved to the pixels of the substrate, and the light emitting devices are aligned to each pixel. Therefore, the self-assembly method is attracting attention as a next-generation transfer method because it may quickly and accurately transfer numerous light emitting devices onto the substrate.

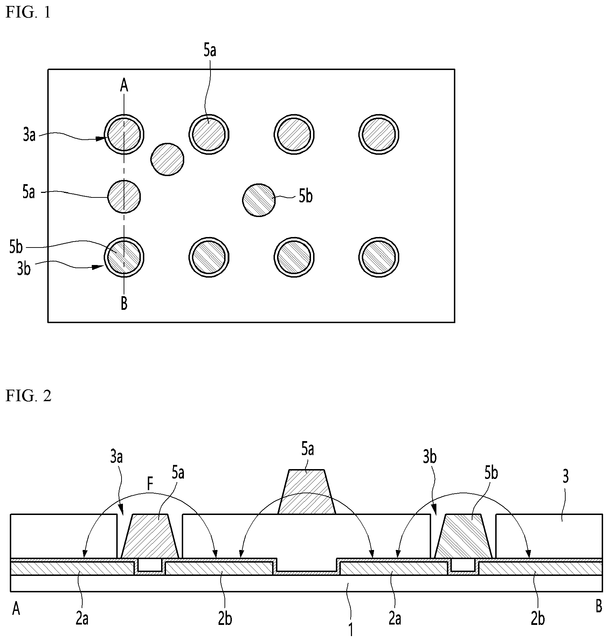

FIG. 1 is a plan view showing a display device according to the applicant's undisclosed technology, and FIG. 2 is a cross-sectional view showing a display device according to the applicant's undisclosed technology.

As shown in FIGS. 1 and 2, in order to assemble LEDs 5a and 5b using a self-assembly method, assembly wirings 2a and 2b are arranged on the substrate 1.

LEDs 5a and 5b are assembled in the assembly holes 3a, 3b by the dielectrophoretic force F formed between the first assembly wiring 2a and the second assembly wiring 2b. That is, the red LED 5a is assembled in the red assembly hole 3a, and the green LED 5b is assembled in the green assembly hole 5b.

However, since the dielectrophoretic force F is formed not only on the assembly holes 3a, 3b but also on the partition wall 3 between the assembly holes 3a, 3b, the red LED 5a may be attached to an upper surface of the partition wall 3 by this dielectrophoretic force F. In the drawing, a red LED 5a is shown attached to the upper surface of the partition 3, but a green LED 5b or a blue LED may also be attached.

When the red LED 5a is attached to the upper surface of the partition wall 3, the flow of other LEDs, that is, the green LED 5b or blue LED, is interrupted by the red LED 5a on the partition wall 3, thereby blocking the other LEDs, there is a problem that the assembly rate is reduced as there are frequent cases where it may not be assembled in the corresponding assembly hole 3b.

In addition, the LEDs 5a and 5b attached to the partition 3 are discarded, which causes a problem of increased material costs.

Additionally, during the assembly process for the green LED 5b, there is a problem that an assembly error occurs when the red LED 5a attached to the partition 3 is assembled into the green assembly hole 5b.

In addition, there is a problem that connection defects such as disconnection of the electrode wires occur during the electrode wire connection process due to the red LED 5a attached on the partition 3.

In addition, if a process for removing the LEDs 5a and 5b attached to the partition 3 is added, the manufacturing process becomes complicated and the manufacturing process time increases, which causes a decrease in productivity. Even if a process for removing the LEDs 5a and 5b attached to the partition 3 is added, it is virtually impossible to completely remove the LEDs 5a and 5b attached to the partition 3, so various problems may still arise.

### Disclosure

### Technical Problem

The embodiment is to solve the above-mentioned problems and other problems.

Another object of the embodiment is to provide a display device that may improve the assembly rate.

Another object of the embodiment is to provide a display device that may reduce material costs.

Another object of the embodiment is to provide a display device that may prevent assembly errors.

Another object of the embodiment is to provide a display device that may prevent electrical connection failure.

Another object of the embodiment is to provide a display device that may increase productivity.

The technical problems of the embodiments are not limited to those described in this item and include those that may be understood through the description of the invention.

### Technical solution

According to one aspect of the embodiment to achieve the above or other objects, a display device may include: a substrate having a plurality of an assembly areas and a non-assembly area; a first partition disposed on the plurality of the assembly areas and having an assembly hole; a second partition disposed on the non-assembly area; and a semiconductor light emitting device in the assembly hole, wherein the second partition has a thickness greater than the first partition.

It may include a protrusion placed in the plurality of the assembly areas.

A difference value between a thickness of the second partition and the thickness of the first partition may be greater than or equal to the thickness of the protrusion.

The protrusion may be an insulating member.

The protrusion may be part of the substrate.

The second partition may include a second-first partition on the first assembly wiring and the second assembly wiring; and a second-second partition disposed on the substrate.

A thickness of the second-first partition may be greater than a thickness of the first partition, and a thickness of the second-second partition may be greater than the thickness of the second-first partition.

The protrusion may be the first assembly pattern and the second assembly pattern.

The first assembly pattern has a thickness greater than the thickness of the first assembly wiring,

The second assembly pattern may have a thickness greater than the thickness of the second assembly wiring.

An upper surface of each of the first partition, the second-first partition, and the second-second partition may be located on the same plane, and a lower surface of each of the first partition, the second-first partition, and the second-second partition may not be located on the same plane.

### Advantageous Effects

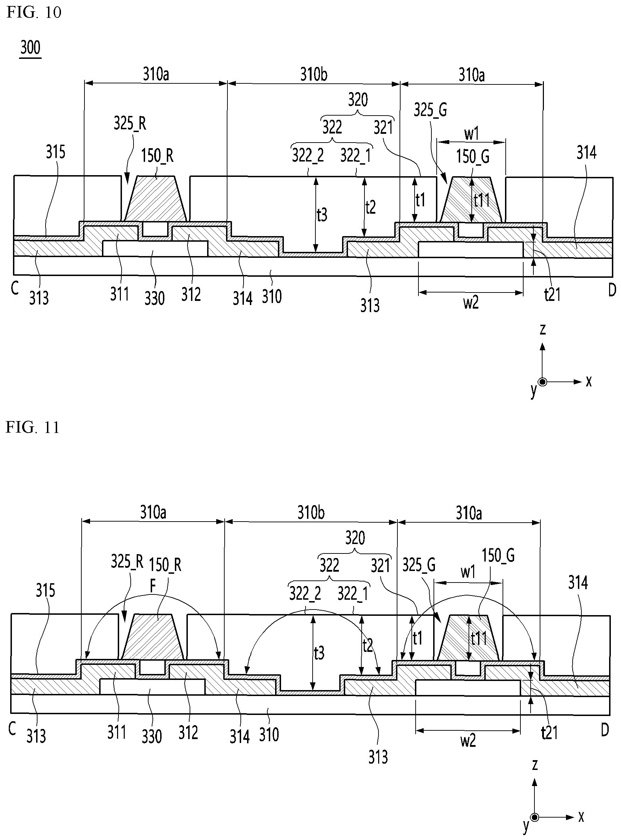

In the embodiment, as shown in FIGS. 10, 13, and 15, by placing protrusion (330, 340, 350) in the assembly area 310a, the thickness of the second partition 322 corresponding to the non-assembly area 310b may be made larger than the thickness of the first partition 321 corresponding to the assembly area 310a. Accordingly, the semiconductor light emitting devices 150_R, 150_G and 150_B can be assembled only in the assembly holes 325_R, 325_G and 325_B formed in the first partition 321, the semiconductor light emitting device 150_R, 150_G and 150_B may not be attached to the upper surface of the second partition 322.

This structure has the following technical effects.

Since the semiconductor light emitting device is not attached to the upper surface of the second partition 322, the flow of other semiconductor light emitting devices is not interrupted by the semiconductor light emitting device on the second partition 322, so other semiconductor light emitting devices may be assembled in the corresponding assembly hole, thereby improving the assembly rate.

In addition, since the semiconductor light emitting device is not attached to the upper surface of the second partition 322, the semiconductor light emitting device is not attached to the second partition 322 and discarded, thereby reducing material costs.

In addition, since the semiconductor light emitting device is not attached to the upper surface of the second partition 322, during the assembly process of another semiconductor light emitting device, an assembly error may be prevented in which the semiconductor light emitting device attached to the upper surface of the second partition 322 is assembled into the assembly hole where another semiconductor light emitting device is to be assembled.

In addition, since a semiconductor light emitting device is not attached to the upper surface of the second partition 322, connection defects such as disconnection of electrode wires may be prevented during the electrode wire connection process.

In addition, since the semiconductor light emitting device is not attached to the upper surface of the second partition 322, an additional process of removing the semiconductor light emitting device attached to the upper surface of the second partition 322 is not required, and thus the manufacturing process is simple and the manufacturing process time is shortened, which may improve productivity.

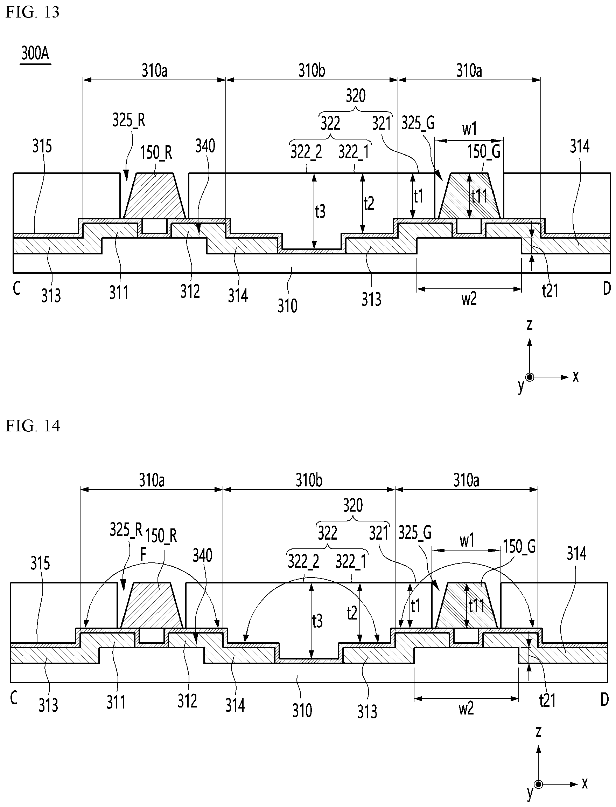

Meanwhile, by using part of the substrate 310 as protrusion 340 (FIG. 13) or using the first assembly pattern 311 and second assembly pattern 312 as protrusion 350, there is no need to provide a separate protrusion, so that the structure is simple and costs may be reduced.

Additional scope of applicability of the embodiments will become apparent from the detailed description below. However, since various changes and modifications within the spirit and scope of the embodiments may be clearly understood by those skilled in the art, the detailed description and specific embodiments, such as preferred embodiments, should be understood as being given by way of example only.

### Description of Drawings

FIG. 1 is a plan view showing a display device according to the applicant's undisclosed technology.
FIG. 2 is a cross-sectional view showing a display device according to the applicant's undisclosed technology.
FIG. 3 shows the living room of a house where a display device according to an embodiment is placed.
FIG. 4 is a block diagram schematically showing a display device according to an embodiment.
FIG. 5 is a circuit diagram showing an example of the pixel of FIG. 4.
FIG. 6 is an enlarged view of the first panel area in the display device of FIG. 3.
FIG. 7 is an enlarged view of area A2 in FIG. 6.
FIG. 8 is a diagram showing an example in which a light emitting device according to an embodiment is assembled on a substrate by a self-assembly method.
FIG. 9 is a plan view showing a display device according to the first embodiment.
FIG. 10 is a cross-sectional view showing a display device according to the first embodiment.
FIG. 11 shows the distribution of dielectrophoretic force in the display device according to the first embodiment.
FIG. 12 is a graph showing the electric field intensity for each of the edge of the chip and the edge of the cup when a chip with a height (or thickness) of 4.1µm is assembled in the assembly hole.
FIG. 13 is a cross-sectional view showing a display device according to a second embodiment.
FIG. 14 shows the distribution of dielectrophoretic force in the display device according to the second embodiment.
FIG. 15 is a cross-sectional view showing a display device according to a third embodiment.
FIG. 16 shows the distribution of dielectrophoretic force in the display device according to the third embodiment.

The size, shape, and dimensions of the components shown in the drawings may be different from the actual ones. In addition, although the same components are shown in different sizes, shapes, and numbers between drawings, this is only an example in the drawings, and identical components may have the same size, shape, and numerical value between drawings.

### Mode for Invention

Hereinafter, embodiments disclosed in the present specification will be described in detail with reference to the attached drawings, but identical or similar components will be assigned the same reference numbers regardless of the reference numerals, and duplicate descriptions thereof will be omitted. The suffixes 'module' and 'part' for components used in the following description are given or used interchangeably in consideration of ease of specification preparation, and do not have distinct meanings or roles in themselves. Additionally, the attached drawings are intended to facilitate easy understanding of the embodiments disclosed in this specification, and the technical idea disclosed in this specification is not limited by the attached drawings. Additionally, when an element such as a layer, region or substrate is referred to as being 'on' another component, this includes either directly on the other element or there may be other intermediate elements in between.

Display devices described in this specification may include TVs, shines, mobile phones, smart phones, head-up displays (HUDs) for automobiles, backlight units for laptop computers, and displays for VR or AR. etc. However, the configuration according to the embodiment described in this specification may be applied to a device capable of displaying even if it is a new product type that is developed in the future.

Hereinafter, a light emitting device and a display device including the same according to an embodiment will be described.

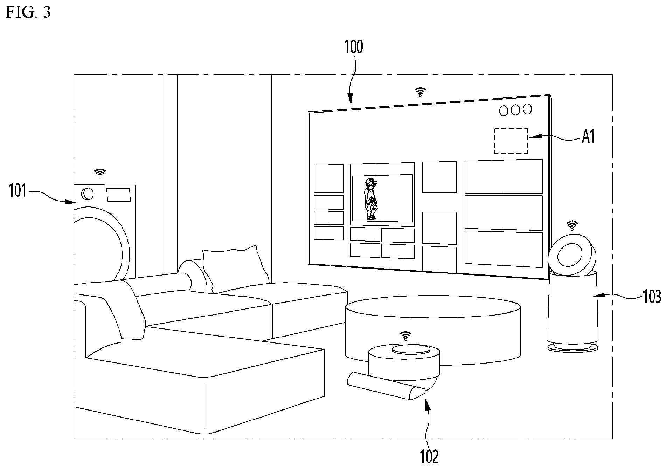

FIG. 3 shows a living room of a house where a display device according to an embodiment is placed.

Referring to FIG. 3, the display device 100 of the embodiment may display the status of various electronic products such as a washing machine 101, a robot vacuum cleaner 102, and an air purifier 103 and it is possible to communicate with each electronic product based on IOT and control each electronic product based on the user's setting data.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

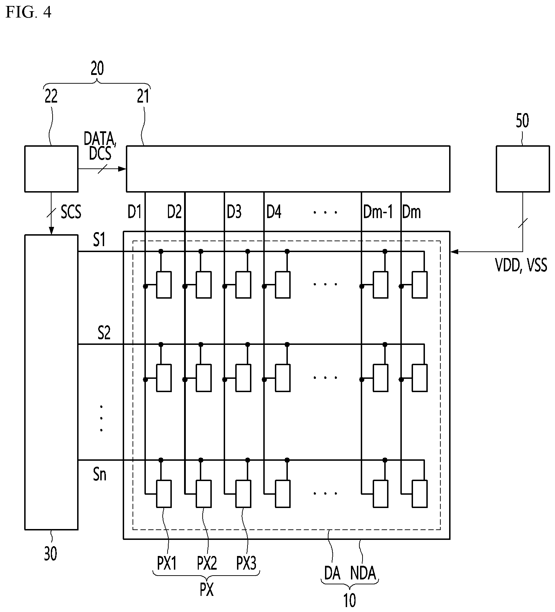

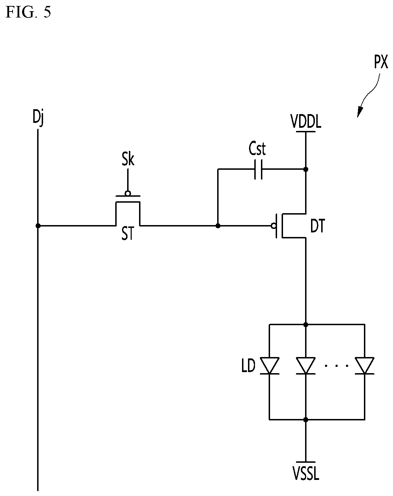

FIG. 4 is a block diagram schematically showing a display device according to an embodiment, and FIG. 5 is a circuit diagram showing an example of the pixel of FIG. 4.

Referring to FIGS. 4 and 5, a display device according to an embodiment may include a display panel 10, a driving circuit 20, a scan driver 30, and a power supply circuit 50.

The display device 100 of the embodiment may drive a light emitting device in an active matrix (AM, Active Matrix) method or a passive matrix (PM, Passive Matrix) method.

The driving circuit 20 may include a data driving unit 21 and a timing control unit 22.

The display panel 10 may be rectangular, but there is no limitation thereto. That is, the display panel 10 may be formed in a circular or oval shape. At least one side of the display panel 10 may be bent to a predetermined curvature.

The display panel 10 may be divided into a display area DA and a non-display area NDA disposed around the display area DA. The display area DA is an area where pixels PX are formed to display an image. The display panel 10 may include a data lines (D1 to Dm, m is an integer greater than 2), scan lines (S1 to Sn, n is an integer of 2 or more) that intersect with the data lines (D1 to Dm), a high-potential voltage line VDDL supplied with high-potential voltage, a low-potential voltage line VSSL supplied with low-potential voltage, and a pixels PX connected to the data lines (D1 to Dm) and the scan lines (S1 to Sn).

Each of the pixels PX may include a first sub-pixel PX1, a second sub-pixel PX2, and a third sub-pixel PX3. The first sub-pixel PX1 may emit a first color light of a first main wavelength, the second sub-pixel PX2 may emit a second color light of a second main wavelength, and the third sub-pixel PX3 may emit third color light of the third main wavelength. The first color light may be red light, the second color light may be green light, and the third color light may be blue light, but are not limited thereto. Additionally, in FIG. 4, it is illustrated that each pixel PX includes three sub-pixels, but the present invention is not limited thereto. That is, each pixel PX may include four or more sub-pixels.

Each of the first sub-pixel PX1, the second sub-pixel PX2, and the third sub-pixel PX3 may be connected at least one of the data lines (D1 to Dm), at least one of the scan lines (S1 to Sn) and the high-potential voltage line VDDL. As shown in FIG. 5, the first sub-pixel PX1 may include light emitting devices LD, a plurality of transistors for supplying current to the light emitting devices LD, and at least one capacitor Cst.

Although not shown in the drawing, each of the first sub-pixel PX1, the second sub-pixel PX2, and the third sub-pixel PX3 may include only one light emitting device LD and at least one capacitor Cst.

Each of the light emitting devices LD may be a semiconductor light emitting diode including a first electrode, a plurality of conductive semiconductor layers, and a second electrode. Here, the first electrode may be an anode electrode and the second electrode may be a cathode electrode, but this is not limited.

The light emitting device LD may be one of a horizontal light emitting device, a flip chip type light emitting device, and a vertical light emitting device.

The plurality of transistors, as shown in FIG. 5, may include a driving transistor DT that supplies current to the light emitting devices LD, and a scan transistor ST that supplies a data voltage to the gate electrode of the driving transistor DT. The driving transistor DT may include a gate electrode connected to the source electrode of the scan transistor ST, a source electrode connected to a high-potential voltage line VDDL to which a high-potential voltage is applied, and a drain electrode connected to the first electrodes of light emitting devices LD. The scan transistor ST may include a gate electrode connected to the scan line (Sk, k is an integer satisfying 1≤k≤n), a source electrode connected to the gate electrode of the driving transistor DT and a drain electrode connected to the data line (Dj, j is an integer satisfying 1≤j≤m).

The capacitor Cst is formed between the gate electrode and the source electrode of the driving transistor DT. The storage capacitor Cst charges the difference value between the gate voltage and source voltage of the driving transistor DT.

The driving transistor DT and the scan transistor ST may be formed of a thin film transistor. In addition, in FIG. 5, the driving transistor DT and the scan transistor ST are mainly described as being formed of a P-type MOSFET (Metal Oxide Semiconductor Field Effect Transistor), but the present invention is not limited thereto. The driving transistor DT and scan transistor ST may be formed of an N-type MOSFET. In this case, the positions of the source and drain electrodes of the driving transistor DT and the scan transistor ST may be changed.

In addition, in FIG. 5, although the first sub-pixel PX1, the second sub-pixel PX2, and the third sub-pixel PX3 each include 2T1C (2 Transistor - 1 capacitor) with one driving transistor DT, one scan transistor ST and one capacitor Cst, but the present invention is not limited to this. Each of the first sub-pixel PX1, the second sub-pixel PX2, and the third sub-pixel PX3 may include a plurality of scan transistors ST and a plurality of capacitors Cst.

Since the second sub-pixel PX2 and the third sub-pixel PX3 may be represented by substantially the same circuit diagram as the first sub-pixel PX1, detailed descriptions thereof will be omitted.

The driving circuit 20 outputs signals and voltages to drive the display panel 10. For this object, the driving circuit 20 may include a data driving unit 21 and a timing control unit 22.

The data driving unit 21 receives digital video data DATA and source control signal DCS from the timing control unit 22. The data driving unit 21 converts digital video data DATA into analog data voltages according to the source control signal DCS and supplies them to the data lines (D1 to Dm) of the display panel 10.

The timing control unit 22 receives digital video data DATA and timing signals from the host system. Timing signals may include a vertical sync signal, a horizontal sync signal, a data enable signal, and a dot clock. The host system may be an application processor in a smartphone or tablet PC, a monitor, or a system-on-chip in a TV

The timing control unit 22 generates control signals to control the operation timing of the data driving unit 21 and the scan driver 30. Control signals may include a source control signal DCS for controlling the operation timing of the data driving unit 21 and a scan control signal SCS for controlling the operation timing of the scan driver 30.

The driving circuit 20 may be arranged in a non-display area NDA provided on one side of the display panel 10. The driving circuit 20 may be formed of an integrated circuit (IC) and mounted on the display panel 10 using a COG (chip on glass) method, a COP (chip on plastic) method, or an ultrasonic bonding method, but the present invention is not limited to this. For example, the driving circuit 20 may be mounted on a circuit board (not shown) rather than on the display panel 10.

The data driving unit 21 is mounted on the display panel 10 using a COG (chip on glass) method, a COP (chip on plastic) method, or an ultrasonic bonding method, and the timing control unit 22 may be mounted on a circuit board.

The scan driver 30 receives a scan control signal SCS from the timing control unit 22. The scan driver 30 generates scan signals according to the scan control signal SCS and supplies them to the scan lines (S1 to Sn) of the display panel 10. The scan driver 30 may include a plurality of transistors and be formed in the non-display area NDA of the display panel 10. Alternatively, the scan driver 30 may be formed as an integrated circuit, and in this case, it may be mounted on a gate flexible film attached to the other side of the display panel 10.

The circuit board may be attached to pads provided at one edge of the display panel 10 using an anisotropic conductive film. Because of this, the lead lines of the circuit board can be electrically connected to the pads. The circuit board may be a flexible printed circuit board, a printed circuit board, or a flexible film such as a chip on film. The circuit board may be bent toward the bottom of the display panel 10. Because of this, one side of the circuit board is attached to one edge of the display panel 10, and the other side is placed below the display panel 10 and can be connected to a system board on which the host system is mounted.

The power supply circuit 50 may generate voltages necessary for driving the display panel 10 from the main power supplied from the system board and supply them to the display panel 10. For example, the power supply circuit 50 generates a high potential voltage VDD and a low potential voltage VSS to drive the light emitting devices LD of the display panel 10 from the main power supply, and it may be supplied to the high potential voltage line VDDL and the low potential voltage line VSSL of the display panel 10. Additionally, the power supply circuit 50 may generate and supply driving voltages for driving the driving circuit 20 and the scan driver 30 from the main power supply.

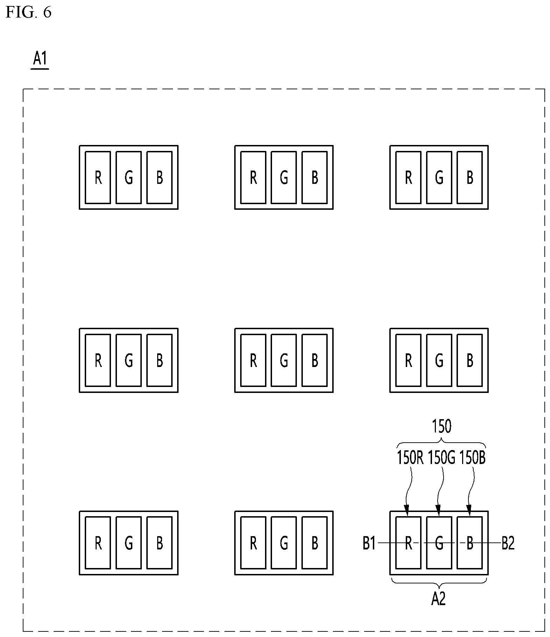

FIG. 6 is an enlarged view of the first panel area in the display device of FIG. 3.

Referring to FIG. 6, the display device 100 of the embodiment may be manufactured by mechanically and electrically connecting a plurality of panel areas, such as the first panel area A1, by tiling.

The first panel area A1 may include a plurality of light emitting devices 150 arranged for each unit pixel (PX in FIG. 4).

For example, the unit pixel PX may include a first sub-pixel PX1, a second sub-pixel PX2, and a third sub-pixel PX3. For example, a plurality of red light emitting devices 150R may be disposed in the first sub-pixel PX1, a plurality of green light emitting devices 150G may be disposed in the second sub-pixel PX2, and a plurality of blue light emitting devices 150B may be disposed in the third sub-pixel PX3. The unit pixel PX may further include a fourth sub-pixel in which a light emitting device is not disposed, but this is not limited.

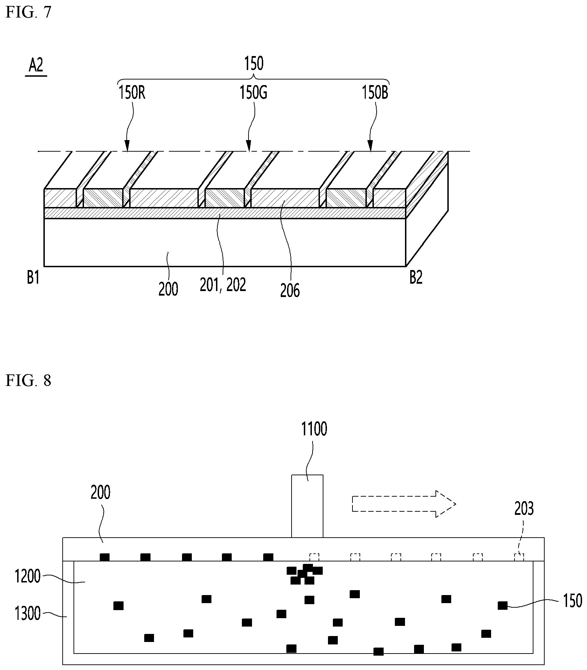

FIG. 7 is an enlarged view of area A2 in FIG. 6.

Referring to FIG. 7, the display device 100 of the embodiment may include a substrate 200, an assembly wiring 201 and 202, an insulating layer 206, and a plurality of light emitting devices 150. More components may be included than this.

The assembly wiring may include first assembly wiring 201 and second assembly wiring 202 spaced apart from each other. The first assembly wiring 201 and the second assembly wiring 202 may be provided to generate dielectrophoretic force to assemble the light emitting device 150. For example, the light emitting device 150 may be one of a horizontal light emitting device, a flip chip type light emitting device, and a vertical light emitting device.

The light emitting device 150 may include a red light emitting device 150, a green light emitting device 150G, and a blue light emitting device 150B0 to form a unit pixel (sub-pixel), but is not limited to this, and it is also possible to implement red and green colors by using red phosphors and green phosphors, respectively.

The substrate 200 may be a support member that supports components disposed on the substrate 200 or a protection member that protects the components.

The substrate 200 may be a rigid substrate or a flexible substrate. The substrate 200 may be formed of sapphire, glass, silicon, or polyimide. Additionally, the substrate 200 may include a flexible material such as PEN (Polyethylene Naphthalate) or PET (Polyethylene Terephthalate). Additionally, the substrate 200 may be a transparent material, but is not limited thereto.

The substrate 200 may be a backplane equipped with circuits in the sub-pixels (PX1, PX2, PX3) shown in FIGS. 4 and 5, such as transistors (ST, DT), capacitors Cst, signal wires, etc., but there is no limitation to this.

The insulating layer 206 may include an insulating and flexible organic material such as polyimide, PAC, PEN, PET, polymer, etc., or an inorganic material such as silicon oxide (SiO2) or silicon nitride series (SiNx), and it may be integrated with the substrate 200 to form one substrate.

The insulating layer 206 may be a conductive adhesive layer that has adhesiveness and conductivity, and the conductive adhesive layer may be flexible and enable a flexible function of the display device. For example, the insulating layer 206 may be an anisotropic conductive film (ACF) or a conductive adhesive layer such as an anisotropic conductive medium or a solution containing conductive particles. The conductive adhesive layer may be a layer that is electrically conductive in a direction perpendicular to the thickness, but electrically insulating in a direction horizontal to the thickness.

The insulating layer 206 may include an assembly hole 203 into which the light emitting device 150 is inserted. Therefore, during self-assembly, the light emitting device 150 may be easily inserted into the assembly hole 203 of the insulating layer 206. The assembly hole 203 may be called an insertion hole, fixing hole, alignment hole, etc.

The assembly hole 203 may be different depending on the shape of the light emitting device 150. For example, the red light emitting device, the green light emitting device, and the blue light emitting device each have different shapes, and may have an assembly hole 203 having a shape corresponding to the shape of each light emitting device. For example, the assembly hole 30 may include a first assembly hole for assembling a red light emitting device, a second assembly hole for assembling a green light emitting device, and a third assembly hole for assembling a blue light emitting device. For example, the red light emitting device has a circular shape, the green light emitting device has a first oval shape with a first minor axis and a second major axis, the blue light emitting device may have a second oval shape with a second minor axis and a second major axis, but there is no limitation to this. The second major axis of the oval shape of the blue light emitting device may be larger than the second major axis of the oval shape of the green light emitting device, and the second minor axis of the oval shape of the blue light emitting device may be smaller than the first minor axis of the oval shape of the green light emitting device.

Meanwhile, methods of mounting the light emitting device 150 on the substrate 200 may include, for example, a self-assembly method (FIG. 8) and a transfer method.

FIG. 8 is a diagram showing an example in which a light emitting device according to an embodiment is assembled on a substrate by a self-assembly method.

The self-assembly method of the light emitting device will be described with reference to FIGS. 7 and 8.

The substrate 200 may be a panel substrate of a display device. In the following description, the substrate 200 will be described as a panel substrate of a display device, but the embodiment is not limited thereto.

The substrate 200 may be formed of glass or polyimide. Additionally, the substrate 200 may include a flexible material such as PEN (Polyethylene Naphthalate) or PET (Polyethylene Terephthalate). Additionally, the substrate 200 may be a transparent material, but is not limited thereto.

Referring to FIG. 8, the light emitting device 150 may be inserted into the chamber 1300 filled with the fluid 1200. The fluid 1200 may be water such as ultrapure water, but is not limited thereto. The chamber may be called a water tank, container, vessel, etc.

After this, the substrate 200 may be disposed on the chamber 1300. Depending on the embodiment, the substrate 200 may be introduced into the chamber 1300.

As shown in FIG. 7, a pair of assembly wirings 201 and 202 corresponding to each light emitting device 150 to be assembled may be disposed on the substrate 200.

The assembly wiring 201, 202 may be formed of a transparent electrode (ITO) or may include a metal material with excellent electrical conductivity. For example, assembly wiring 201, 202 may be formed of at least one of titanium (Ti), chromium (Cr), nickel (Ni), aluminum (Al), platinum (Pt), gold (Au), tungsten (W), or molybdenum (Mo) or an alloy thereof.

An electric field is formed in the assembly wiring 201, 202 by an externally supplied voltage, and a dielectrophoretic force may be formed between the assembly wiring 201, 202 by this electric field. The light emitting device 150 may be fixed to the assembly hole 203 on the substrate 200 by this dielectrophoretic force.

The gap between the assembly wiring 201, 202 is formed to be smaller than the width of the light emitting device 150 and the width of the assembly hole 203, so that the assembly position of the light emitting device 150 using an electric field may be fixed more precisely.

An insulating layer 206 is formed on the assembly wiring 201, 202 to protect the assembly wiring 201, 202 from the fluid 1200 and may prevent leakage of current flowing in the assembly wiring 201, 202. The insulating layer 206 may be formed as a single layer or multilayer of an inorganic insulator such as silica or alumina or an organic insulator.

Additionally, the insulating layer 206 may include an insulating and flexible material such as polyimide, PEN, PET, etc., and may be integrated with the substrate 200 to form one substrate.

The insulating layer 206 may be an adhesive insulating layer or a conductive adhesive layer with conductivity. The insulating layer 206 is flexible and may enable flexible functions of the display device.

The insulating layer 206 has a partition, and an assembly hole 203 may be formed by this partition. For example, when forming the substrate 200, a portion of the insulating layer 206 is removed, so that each of the light emitting devices 150 may be assembled into the assembly hole 203 of the insulating layer 206.

The assembly hole 203 is formed in the substrate 200 to which the light emitting devices 150 are coupled, and the surface where the assembly hole 203 is formed may be in contact with the fluid 1200. The assembly hole 203 may guide the exact assembly position of the light emitting device 150.

Meanwhile, the assembly hole 203 may have a shape and size corresponding to the shape of the light emitting device 150 to be assembled at the corresponding location. Accordingly, it is possible to prevent another light emitting device from being assembled or a plurality of light emitting devices from being assembled into the assembly hole 203.

Referring again to FIG. 8, after the substrate 200 is disposed, the assembly device 1100 including a magnetic material may move along the substrate 200. For example, a magnet or electromagnet may be used as a magnetic material. The assembly device 1100 may move while in contact with the substrate 200 in order to maximize the area to which the magnetic field is applied within the fluid 1200. Depending on the embodiment, the assembly device 1100 may include a plurality of magnetic materials or a magnetic material of a size corresponding to that of the substrate 200. In this case, the moving distance of the assembly device 1100 may be limited to within a predetermined range.

The light emitting device 150 in the chamber 1300 may move toward the assembly device 1100 by the magnetic field generated by the assembly device 1100.

While moving toward the assembly device 1100, the light emitting device 150 may enter the assembly hole 203 and come into contact with the substrate 200.

At this time, by the electric field applied by the assembly wiring 201, 202 formed on the substrate 200, the light emitting device 150 in contact with the substrate 200 may be prevented from being separated by movement of the assembly device 1100.

In other words, the time required for each of the light emitting devices 150 to be assembled on the substrate 200 may be drastically shortened by the self-assembly method using the electromagnetic field described above. so that large-area, high-pixel displays may be implemented more quickly and economically.

A predetermined solder layer (not shown) is further formed between the light emitting device 150 assembled on the assembly hole 203 of the substrate 200 and the substrate 200, and may improve the bonding strength of the light emitting device 150.

Afterwards, electrode wiring (not shown) is connected to the light emitting device 150 and power may be applied.

Next, although not shown, at least one insulating layer may be formed through a post-process. At least one insulating layer may be transparent resin or resin containing a reflective material or a scattering material.

Meanwhile, the embodiment provides a display device that prevents a semiconductor light emitting device from being attached to the upper surface of a second partition by making the thickness of the second partition in the non-assembly area larger than the thickness of the first partition around the assembly hole in the assembly area where the first electrode pattern and the second electrode pattern are placed, the dielectrophoretic force does not apply to the second partition.

Descriptions omitted below may be easily understood from FIGS. 3 to 8 and the description given above in relation to the corresponding drawings.

### [First Example]

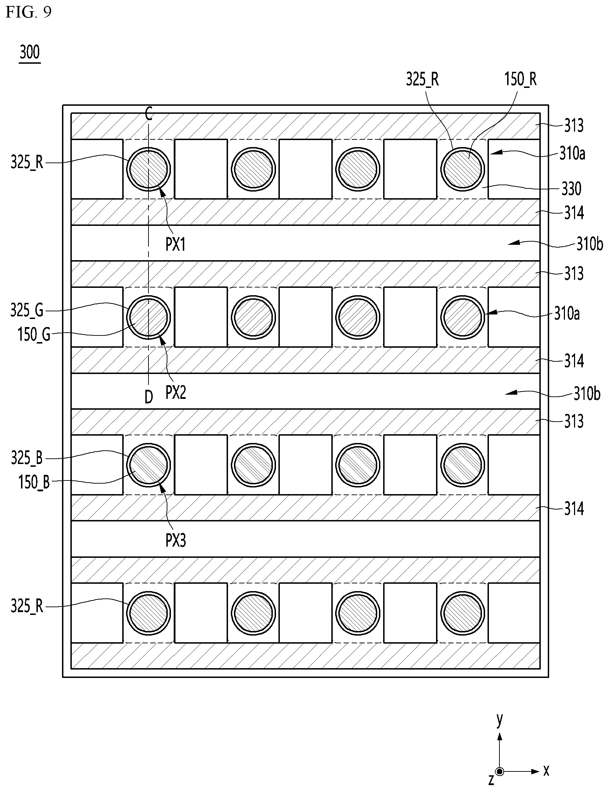

FIG. 9 is a plan view showing the display device according to the first embodiment, and FIG. 10 is a cross-sectional view showing the display device according to the first embodiment.

Referring to FIGS. 9 and 10, the display device 300 according to the first embodiment may include a plurality of pixels PX. A plurality of pixels PX may be arranged in a matrix. For example, the plurality of pixels PX may have pixel rows arranged along a first direction (x-direction) and pixel columns arranged along a second direction (y-direction).

Each of the plurality of pixels PX may include a plurality of sub-pixels PX1, PX2, and PX3. Each of the plurality of pixels PX may display a unit image. That is, each of the plurality of pixels PX is capable of full color implementation.

The plurality of sub-pixels may include a first sub-pixel PX1, a second sub-pixel PX2, and a third sub-pixel PX3. In the drawing, the first sub-pixel PX1, the second sub-pixel PX2, and the third sub-pixel PX3 are shown as having the same size, but they may be different from each other.

For example, a first semiconductor light emitting device 150_R may be disposed in a first sub-pixel PX1, a second semiconductor light emitting device 150_G may be disposed in a second sub-pixel PX2, and a third semiconductor light emitting device may be disposed in a third sub-pixel PX3. For example, the first semiconductor light emitting device 150_R may include a red semiconductor light emitting device, the second semiconductor light emitting device 150_G may include a green semiconductor light emitting device, the third semiconductor light emitting device 150_B may include a blue semiconductor light emitting device. For example, each of the first semiconductor light emitting device 150_R, the second semiconductor light emitting device 150_G, and the third semiconductor light emitting device 150_B may have a micrometer-sized semiconductor light emitting device or a nanometer-sized semiconductor light emitting device. For example, the first semiconductor light emitting device 150_R, the second semiconductor light emitting device 150_G, and the third semiconductor light emitting device 150_B each have a diameter of 10µm or less, so ultra-high resolution display may be possible.

In each of the first sub-pixel PX1, the second sub-pixel PX2, and the third sub-pixel PX3, the same sub-pixels may be repeatedly arranged along the first direction. For example, the first sub-pixel PX1 is repeatedly arranged along the first direction, and the second sub-pixel PX2 may be repeatedly arranged along the first direction, and the third sub-pixel PX3 may be repeatedly arranged along the first direction. The repeated arrangement of the same sub-pixels along the first direction may be called a stripe column arrangement. For example, the first stripe column may include first sub-pixels PX1 repeatedly arranged along the first direction, the second stripe column may include second sub-pixels PX2 repeatedly arranged along the first direction, and the third stripe column may include third sub-pixels PX3 repeatedly arranged along the first direction.

The first sub-pixel PX1, the second sub-pixel PX2, and the third sub-pixel PX3 may be repeatedly arranged along the second direction. For example, the first sub-pixel PX1, the second sub-pixel PX2, and the third sub-pixel PX3 are arranged in that order along the second direction, and adjacent to the third sub-pixel PX3, the first sub-pixel PX1, the second sub-pixel PX2, and the third sub-pixel PX3 may be arranged in that order.

Meanwhile, the display device 300 according to the first embodiment may include a substrate 310, partitions 321 and 322, and semiconductor light emitting devices 150_R, 150_G, and 150_B. The display device 300 according to the first embodiment may include more components than these, but is not limited thereto.

The substrate 310 may be a support member that supports components disposed on the substrate 310 or a protection member that protects the components.

The substrate 310 may have a plurality of assembly areas 310a and non-assembly areas 310b. For example, the assembly area 310a may be an area where semiconductor light emitting devices 150_R, 150_G and 150_B are assembled, and the non-assembly area 310b may be an area where semiconductor light emitting devices 150_R, 150_G and 150_B are not assembled. For example, the assembly area 310a may be a light emitting area where light is generated by the semiconductor light emitting devices 150_R, 150_G, and 150_B. For example, the non-assembly area 310b may be a non-emission area in which light is not emitted because the semiconductor light emitting devices 150_R, 150_G, and 150_B are not disposed.

The partitions 321 and 322 may be disposed on the substrate 310. The partitions 321 and 322 may have assembly holes 325_R, 325_G and 325_B for assembling the semiconductor light emitting devices 150_R, 150_G and 150_B. For example, the insulating layer 315 may be exposed within the assembly holes 325_R, 325_G and 325_B. For example, the lower surface of the assembly hole 325_R, 325_G and 325_B may be the upper surface of the insulating layer 315. For example, assembly holes 325_R, 325_G and 325_B may be placed in each of the sub-pixels PX1, PX2, and PX3.

A thickness t1, t2 and t3 of the partition 321 and 322 may be determined by considering the thickness t11 of the semiconductor light emitting device 150_R, 150_G and 150_B. For example, the thickness t1 of the partitions 321 and 322 may be smaller than the thickness t11 of the semiconductor light emitting devices 150_R, 150_G and 150_B, but this is not limited. Accordingly, the upper surfaces of the semiconductor light emitting devices 150_R, 150_G and 150_B may be positioned higher than the upper surfaces of the partitions 321 and 322. That is, the upper side of the semiconductor light emitting device 150_R, 150_G and 150_B may protrude upward from the upper surface of the partition 321 and 322.

A size of the assembly hole 325_R, 325_G and 325_B may be determined by considering the tolerance margin for forming the assembly hole 325_R, 325_G and 325_B and the margin for easily assembling the semiconductor light emitting device 150_R, 150_G and 150_B within the assembly hole 325_R, 325_G and 325_B. For example, the size of the assembly hole 325_R, 325_G and 325_B may be larger than the size of the semiconductor light emitting device 150_R, 150_G and 150_B. For example, when a semiconductor light emitting device 150_R, 150_G and 150_B is assembled in the center of an assembly hole 325_R, 325_G and 325_B, the outer side of the semiconductor light emitting device 150_R, 150_G and 150_B may be spaced apart from the inner side of the assembly hole 325_R, 325_G and 325_B.

Each of the semiconductor light emitting devices 150_R, 150_G and 150_B may be assembled in the assembly hole 325_R, 325_G and 325_B to generate predetermined light. The semiconductor light emitting device may include a plurality of red semiconductor light emitting devices 150_R, green semiconductor light emitting devices 150_G, and blue semiconductor light emitting devices 150_B. For example, the red semiconductor light emitting device 150_R may be disposed in the first assembly hole 325_R of the first sub-pixel PX1, the green semiconductor light emitting device 150_G may be disposed in the second assembly hole 325_G of the second sub-pixel PX2, and the blue semiconductor light emitting device 150_B may be disposed in the third assembly hole 325_B of the third sub-pixel PX3.

Meanwhile, the display device 300 according to the first embodiment may include a first assembly pattern 311, a second assembly pattern 312 312, a first assembly wiring 313, and a second assembly wiring 324. The first assembly pattern 311, second assembly pattern 312, first assembly wiring 313, and second assembly wiring 324 may generate an electric field to form a dielectrophoretic force.

The first assembly pattern 311, second assembly pattern 312, first assembly wiring 313, and second assembly wiring 324 may be arranged between the substrate 310 and the partition.

The first assembly wiring 313 and the second assembly wiring 324 may be arranged along the first direction. The first assembly pattern 311 and the second assembly pattern 312 may be arranged along the second direction. The first assembly pattern 311 may be connected to the first assembly wiring 313, and the second assembly pattern 312 may be connected to the second assembly wiring 324. For example, the first assembly pattern 311 may extend from the first assembly wiring 313 along the second direction, and the second assembly pattern 312 may extend from the second assembly wiring 324 toward the first assembly pattern 311. For example, the first assembly pattern 311 and the second assembly pattern 312 may be arranged to face each other, but this is not limited.

The first voltage and the second voltage may be alternately supplied to the first assembly pattern 311 and the second assembly pattern 312. For example, during the first period, the first voltage is supplied to the first assembly pattern 311 via the first assembly wiring 313, and the second voltage may be supplied to the second assembly pattern 312 via the second assembly wiring 324. For example, during the second period, the second voltage may be supplied to the first assembly pattern 311 via the first assembly wiring 313, and the first voltage is supplied to the second assembly pattern 312 via the second assembly wiring 324. For example, the first voltage may be a (+) voltage and the second voltage may be a (-) voltage. For example, the first voltage may be a (+) voltage or a (-) voltage, and the second voltage may be grounded.

An electric field may be generated between the first assembly pattern 311 and the second assembly pattern 312 by the first and second voltages. The dielectrophoretic force may be determined by the electric field, the radius of the semiconductor light emitting device, the dielectric constant of the insulating layer 315, etc. Accordingly, a dielectrophoretic force may be formed between the first assembly pattern 311 and the second assembly pattern 312.

As shown in FIG. 9, since the first assembly wiring 313 and the second assembly wiring 324 are alternately arranged along the second direction, dielectrophoretic force may be formed not only in the assembly area 310a but also in the non-assembly area 310b.

Typically, the thickness of the partition 11, t2 and t3 is determined so that the dielectrophoretic force is formed from the assembly area 310a to the upper surface of the partition or above.

As shown in FIG. 2, according to the applicant's unpublished technology, when the thickness of the partition 3 in the assembly area and the non-assembly area is the same, a dielectrophoretic force is formed on the partition 3 not only in the assembly area but also in the non-assembly area. Accordingly, during the assembly process of the red semiconductor light emitting device 5a, the red semiconductor light emitting device 5a is not only assembled in the red assembly hole 3a but also attached to the upper surface of the partition 3 in the non-assembly area.

In this way, when the red semiconductor light emitting device 5a is attached to the upper surface of the partition 3 in the non-assembly area, the following problems may occur.

When the red LED 5a is attached to the upper surface of the partition 3, the flow of other LEDs, that is, the green LED 5b or the blue LED, is interrupted by the red LED 5a on the partition 3, so there are frequent cases where other LEDs cannot be assembled in the corresponding assembly hole 3b, which reduces the assembly rate.

In addition, the LEDs 5a and 5b attached to the partition 3 are discarded, which causes a problem of increased material costs.

Additionally, during the assembly process for the green LED, there is a problem that an assembly error occurs when the red LED 5a attached to the partition 3 is assembled into the green assembly hole 5b.

In addition, there is a problem that connection defects such as disconnection of the electrode wiring occur during the electrode wiring connection process due to the red LED 5a attached to the partition 3.

In addition, if a process for removing the LEDs 5a and 5b attached to the partition 3 is added, the manufacturing process becomes complicated and the manufacturing process time increases, causing a decrease in productivity. Even if a process to remove the LEDs 5a and 5b attached to the partition 3 is added, it is virtually impossible to completely remove the LEDs 5a and 5b attached to the partition 3, so various problems still may be caused.

According to the first embodiment, since the thickness t2 and t3 of the partition (hereinafter, referred to as second partition 322) on the non-assembly area 310b is greater than the thickness t1 of the partition (hereinafter referred to as first partition 321) on the assembly area 310a, the above-mentioned problem may be solved by preventing the semiconductor light emitting device from being attached to the upper surface of the second partition 322. In other words, the semiconductor light emitting device may be disposed only in the assembly holes 325_R, 325_G and 325_B formed in the partition of the assembly area 310a and not in other areas, that is, the non-assembly area 310b. The thickness t2 and t3 of the second partition 322 on the non-assembly area 310b is large, so the dielectrophoresis force does not reach over the second partition 322, the semiconductor light emitting device fixed by dielectrophoretic force may not be attached to the upper surface of the second partition 322.

The partition may include a first partition 321 which is disposed on a assembly area 310a and has an assembly hole and a second partition 322 which is disposed on a non-assembly area.

For example, the thickness t2 and t3 of the second partition 322 may be greater than the thickness t1 of the first partition 321.

First assembly pattern 311, first assembly wiring 313, second assembly pattern 312, and second assembly wiring 324 may be placed under the first partition 321 and second partition 322. For example, the first assembly pattern 311 and the second assembly pattern 312 are placed under the first partition 321 corresponding to the assembly area 310a, and the first assembly wiring 313 and the second assembly wiring 324 may be placed under the second partition 322 corresponding to the non-assembly area 310b, but are not limited thereto.

For example, if an upper surfaces of the first partition 321 and the second partition 322 are located on the same plane, and the thickness t2 and t3 of the second partition 322 is greater than the thickness t1 of the first partition 321, a lower surfaces of the first partition 321 and the second partition 322 may be positioned differently from each other.

For example, the first partition 321 and the second partition 322 may not be located on the same plane. That is, the lower surface of the second partition 322 may protrude downward from the lower surface of the first partition 321. Since first assembly pattern 311, first assembly wiring 313, second assembly pattern 312, and second assembly wiring 324 are placed under first partition 321 and second partition 322, the first assembly wiring 313 and second assembly wiring 324 placed below the second partition 322 corresponding to the non-assembly area 310b may be located lower than the first assembly pattern 311 and second assembly pattern 312 placed under first partition 321 corresponding to assembly area 310a.

Therefore, as shown in FIG. 11, Since the dielectrophoretic force formed by the first assembly pattern 311 and the second assembly pattern 312 exposed by the assembly hole 325_R, 325_G and 325_B also affects the first partition 321, the semiconductor light emitting device located on the first partition 321 corresponding to the assembly area 310a may be pulled to the corresponding assembly hole 325_R, 325_G and 325_B and assembled in the corresponding assembly hole 325_R, 325_G and 325_B. In contrast, since the dielectrophoretic force formed by second assembly wiring 324 and second assembly wiring 324 does not affect the second partition 322 due to the thickness of the second partition 322, the semiconductor light emitting device located on the second partition 322 is not attached to the upper surface of the second partition 322 and may move freely.

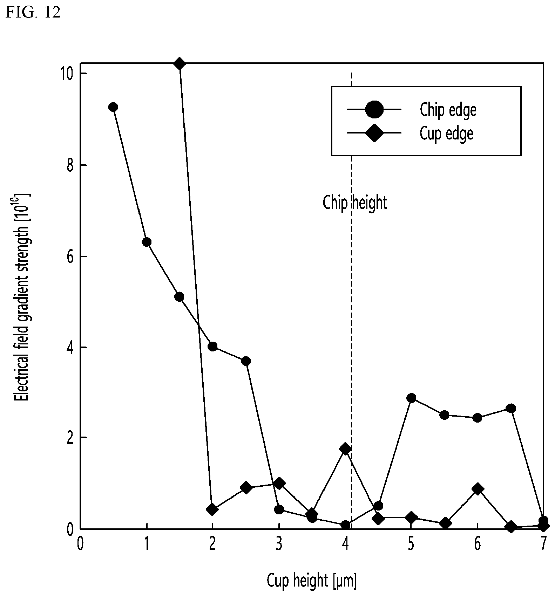

Meanwhile, FIG. 12 is a graph showing the electric field intensity for each of the edge of the chip and the edge of the cup when a chip with a height (or thickness) of 4.1µm is assembled in the assembly hole.

As shown in FIG. 12, it may be seen that the electric field strength of the cup edge and chip edge varies depending on the height (or thickness) of the partition. The cup may represent a partition, and the chip may represent a semiconductor light emitting device.

When the cup height is 2µm or more, the cup edge shows an electric field strength of 2 or less, whereas when the cup height is 3µm to 4.5µm, the chip edge shows an electric field strength of 2 or less. Accordingly, from FIG. 12, the height (or thickness) of the first partition 321 corresponding to the assembly area 310a may be determined in a range of ±20% of the chip height. At the height of the first partition 321 determined in this way, the electric field strength of the cup edge and the electric field strength of the chip edge are low below 2, so it may not be redundantly attached to the chip assembled in the assembly hole to another chip (semiconductor light emitting device).

Meanwhile, the second partition 322 may include a second-first partition 322_1 and a second-second partition 322_2. The second-first partition 322_1 may be named the second partition 322, and the second-second partition 322_2 may be named the third partition.

The second-first partition 322_1 may be disposed on the first assembly wiring 313 and the second assembly wiring 324. The second-second partition 322_2 may be disposed on the substrate 310. That is, the second-second partition 322_2 may not vertically overlap with each of the first assembly wiring 313 and second assembly wiring 324.

The upper surfaces of each of the first partition 321, second-first partition 322_1, and second-second partition 322_2 are located on the same plane, and the lower surfaces of the first partition 321, second-first partition 322_1, and second-second partition 322_2 may not be located on the same plane. That is, the lower surfaces of the first partition 321, second-first partition 322_1, and second-second partition 322_2 may be positioned differently from each other.

For example, the thickness t2 of the second-first partition 322_1 may be greater than the thickness t1 of the first partition 321. If the upper surfaces of the first partition 321, second-first partition 322_1, and second-second partition 322_2 are located on the same plane, the second-first partition 322_1 may protrude downward from the lower surface of the first partition 321. Therefore, the first assembly wiring 313 and second assembly wiring 324 placed under the second-first partition 322_1 may be located lower than the first assembly pattern 311 and second assembly pattern 312 placed under the first partition 321. In this case, even if dielectrophoretic forces are formed between the first assembly pattern 311 and the second assembly pattern 312 and between the first assembly wiring 313 and the second assembly wiring 324, this dielectrophoretic force may affect the first partition 321 corresponding to the assembly area 310a. However, due to the second-first partition 322_1 having a thickness t2 greater than the thickness t1 of the first partition 321, the first assembly wiring 313 and second assembly wiring 324 are located lower than first assembly pattern 311 and second assembly pattern 312, and thus, they do not affect the second-first partition 322_1. Accordingly, a semiconductor light emitting device may be assembled in the assembly holes 325_R, 325_G and 325_B formed in the first partition 321, but the semiconductor light emitting device is not attached to the upper surface of the second partition 322.

For example, the thickness t3 of the second-second partition 322_2 may be greater than the thickness t2 of the second-first partition 322_1. When the upper surfaces of first partition 321, second-first partition 322_1, and second-second partition 322_2 are located on the same plane, the second-second partition 322_2 may protrude downward from the lower surface of the second-first partition 322_1. Since the first assembly pattern 311, second assembly pattern 312, first assembly wiring 313, and second assembly wiring 324 are not placed under the second-second partition 322_2, and since dielectrophoretic forces are not formed below the second-second partition 322_2, inside the second partition 322, and above the second-second partition 322_2, the semiconductor light emitting device is not attached to the upper surface of the second-second partition 322_2.

Meanwhile, the thickness t2 of the second-first partition 322_1 may be greater than the thickness t11 of the semiconductor light emitting device. For example, the thickness t2 of the second-first partition 322_1 may be 1.2 times or more than the thickness t11 of the semiconductor light emitting device. For example, the thickness t2 of the second-first partition 322_1 may be 1.5 times or more than the thickness t11 of the semiconductor light emitting device.

For example, the thickness t2 of the second-first partition 322_1 may be 1.2 times or more than the thickness t1 of the first partition 321. For example, the thickness t2 of the second-first partition 322_1 may be 1.5 times or more than the thickness t1 of the first partition 321.

In summary, according to the first embodiment, by forming the second partition 322, especially the second-first partition 322_1, to have a thicker thickness t2 and t3 than the thickness t1 of the first partition 321, the dielectrophoretic force formed by the first assembly pattern 311 and the second assembly pattern 312 placed below the first partition 321 affects the first partition 321, and thus, the semiconductor light emitting device located on the first partition 321 may be easily assembled in the assembly holes 325_R, 325_G and 325_B formed in the first partition 321. On the other hand, the dielectrophoretic force formed by the first assembly wiring 313 and second assembly wiring 324 placed below the second-first partition 322_1 does not affect the second partition 322 due to the thickness of the second partition 322, so the semiconductor light emitting device may not be attached to the upper surface of the second partition 322. Therefore, the semiconductor light emitting device is not attached to the upper surface of the second partition 322, so the following technical advantages may be obtained.

Since the semiconductor light emitting device is not attached to the upper surface of the second partition 322, the flow of other semiconductor light emitting devices is not interrupted by the semiconductor light emitting device on the second partition 322, so other semiconductor light emitting devices may be assembled in the corresponding assembly hole, thereby improving the assembly rate.

In addition, since the semiconductor light emitting device is not attached to the upper surface of the second partition 322, the semiconductor light emitting device is not attached to the second partition 322 and discarded, thereby reducing material costs.

In addition, sine the semiconductor light emitting device is not attached to the upper surface of the second partition 322, during the assembly process of another semiconductor light emitting device, an assembly error may be prevented in which the semiconductor light emitting device attached to the upper surface of the second partition 322 is assembled into the assembly hole where the other semiconductor light emitting device is to be assembled.

In addition, since a semiconductor light emitting device is not attached to the upper surface of the second partition 322, connection defects such as disconnection of electrode wires may be prevented during the electrode wire connection process.

In addition, since the semiconductor light emitting device is not attached to the upper surface of the second partition 322, an additional process of removing the semiconductor light emitting device attached to the upper surface of the second partition 322 is not required, and thus, the manufacturing process is simple and the manufacturing process time is shortened, which may improve productivity.

Meanwhile, the display device 300 according to the first embodiment may include a protrusion 330.

The protrusion 330 may be placed in the assembly area 310a. For example, protrusion 330 may be placed under the first partition 321 corresponding to the assembly area 310a. For example, protrusion 330 may be placed under the assembly hole 325_R, 325_G and 325_B formed in the first partition 321. For example, protrusion 330 may be placed under first assembly pattern 311 and second assembly pattern 312 under first partition 321.

For example, the protrusion 330 may be placed between the substrate 310 and the first assembly pattern 311 and the second assembly pattern 312 in the assembly area 310a. For example, the protrusion 330 may be placed between the substrate 310 and the first assembly pattern 311 in the assembly area 310a, and may be placed between the substrate 310 and the second assembly pattern 312. For example, protrusion 330 may vertically overlap with the first assembly pattern 311 and vertically overlap with the second assembly pattern 312 in the assembly area 310a.

For example, protrusion 330 may be an island pattern. That is, the protrusion 330 may be located in the assembly area 310a of each of the plurality of sub-pixels PX1, PX2, and PX3. Accordingly, the protrusion 330 may be a pattern spaced apart from each other. For example, the first protrusion is located in the first assembly area of the first sub-pixel PX1, a second protrusion may be located in the second assembly area of the second sub-pixel PX2, and a third protrusion may be located in the third assembly area of the third sub-pixel PX3.

The difference value between the thickness t2 and t3 of the second partition 322 and the thickness t1 of the first partition 321 may be greater than or equal to the thickness t21 of the protrusion 330. For example, the difference value between the thickness t2 and t3 of the second partition 322 and the thickness t1 of the first partition 321 may be equal to the thickness t21 of the protrusion 330. For example, the difference value between the thickness t2 and t3 and the thickness t1 of the first partition 321 may be greater than the thickness t21 of the protrusion 330. Protrusion 330 is placed under the first partition 321 corresponding to the assembly area 310a, but protrusion 330 is not placed under the second partition 322 corresponding to the non-assembly area 310b, so the thickness t1 of the first partition 321 and the thickness t2 and t3 of the second partition 322 may be different. That is, when the upper surfaces of the first partition 321 and the second partition 322 are located on the same plane, the protrusion 330 is not placed under the second partition 322 corresponding to the non-assembly area 310b, since the lower surfaces of the first partition 321 and the second partition 322 are not located on the same plane, the thickness t1 of the first partition 321 and the thickness t2 and t3 of the second partition 322 may vary.

For example, the protrusion 330 may be an insulating member 330. That is, the protrusion 330 may be made of an inorganic material or an organic material. The insulating member 330 may be disposed between the substrate 310 and the first partition 321. For example, in order to increase the dielectrophoretic force, the insulating member 330 may be formed of a material having a dielectric constant, but this is not limited.

As shown in FIG. 9, the protrusion 330 may be square when viewed from above, but various shapes such as circular, oval, etc. are possible. For example, as long as the size (or area) of the protrusion 330 is larger than the size (or area) of the assembly holes 325_R, 325_G and 325_B, the protrusion 330 may have any shape.

In the drawing, although the lower surfaces of the first assembly pattern 311 and the second assembly pattern 312 are shown as being in contact with the upper surface of the insulating member 330, at least one layer may be disposed between the first assembly pattern 311 and the second assembly pattern 312 and the insulating member.

The width w2 of the protrusion 330 may be greater than or equal to the width w1 of the assembly hole 325_R, 325_G and 325_B. For example, the width w2 of the protrusion 330 may be the same as the width w1 of the assembly holes 325_R, 325_G and 325_B. For example, the width w2 of the protrusion 330 may be larger than the width w1 of the assembly holes 325_R, 325_G and 325_B. When the width w2 of the protrusion 330 is greater than the width w1 of the assembly hole 325_R, 325_G and 325_B, the thickness t2 and t3 of the second partition 322 may be greater than the thickness t1 of the first partition 321.

Meanwhile, the semiconductor light emitting device may include a plurality of semiconductor light emitting devices generating the same color light disposed in a plurality of assembly holes 325_R, 325_G and 325_B between the first assembly wiring 313 and the second assembly wiring 324 along the first direction. In this case, the protrusion 330 may be placed under each of a plurality of semiconductor light emitting devices that generate the same color light. When the plurality of semiconductor light emitting devices are red semiconductor light emitting devices, a protrusion 330 may be disposed under each of the plurality of red semiconductor light emitting devices.

In the drawing, although the upper surfaces of each of the first partition 321 and second partition 322 are shown as being located on the same plane, and the lower surfaces of each of the first partition 321 and second partition 322 as being not located on the same plane, the opposite could be. That is, the upper surfaces of the first partition 321 and the second partition 322 may not be located on the same plane, and the lower surfaces of the first partition 321 and the second partition 322 may be located on the same plane.

### [Second Embodiment]

FIG. 13 is a cross-sectional view showing a display device according to a second embodiment.

The second embodiment is the same as the first embodiment except that a part of the substrate 310 is used as a protrusion 340. In the second embodiment, components having the same shape, structure, and/or function as those of the first embodiment are assigned the same reference numerals and detailed descriptions are omitted.

Referring to FIG. 13, a display device 300A according to the second embodiment may include a substrate 310, a protrusion 340, a first assembly pattern 311, a second assembly pattern 312, partition321 and 322 and semiconductor light emitting device150_R, 150_G and 150_B. The display device 300A according to the second embodiment may include more components than these, but is not limited thereto.

The substrate 310 may have a plurality of assembly areas 310a and a non-assembly areas 310b.

The protrusion 340 may be placed in each of the plurality of assembly areas 310a. The protrusion 340 may be disposed between the substrate 310 and the first assembly pattern 311 and the second assembly pattern 312. For example, the protrusion 340 may be placed between the substrate 310 and the first assembly pattern 311. For example, the protrusion 340 may be placed between the substrate 310 and the second assembly pattern 312.

The protrusion 340 may be part of the substrate 310. For example, the protrusion 340 may protrude upward from the upper surface of the substrate 310. For example, the protrusion 340 may protrude from the upper surface of the substrate 310 toward the assembly hole 325_R, 325_G and 325_B or the semiconductor light emitting device. In this case, there is no need to provide a separate protrusion, which simplifies the structure and reduces costs.

By protrusion 340, the first assembly pattern 311 may be positioned higher than the first assembly wiring 313, and the second assembly pattern 312 may be positioned higher than the second assembly wiring 324.

The partition may be disposed on the first assembly pattern 311, second assembly pattern 312, first assembly wiring 313, second assembly wiring 324, and substrate 310.

The partition may have a first partition 321 and a second partition 322. The second partition 322 may have a second-first partition 322_1 and a second-second partition 322_2. The second-first partition 322_1 may be named the second partition 322, and the second-second partition 322_2 may be named the third partition.

An assembly hole 325_R, 325_G and 325_B is formed in the first partition 321 placed in the assembly area 310a, and a semiconductor light emitting device may be placed in the assembly hole 325_R, 325_G and 325_B.

For example, the first partition 321 may be placed in the assembly area 310a, and the second partition 322 may be placed in the non-assembly area 310b. For example, the first assembly pattern 311 and the second assembly pattern 312 may be placed under the first partition 321. For example, the first assembly wiring 313 and the second assembly wiring 324 may be placed under the second partition 322, especially the second-first partition 322_1.

The difference value between the thickness t2 and t3 of the second partition 322 and the thickness t1 of the first partition 321 may be greater than or equal to the thickness t21 of the protrusion 340. For example, the difference value between the thickness t2 of the second-first partition 322_1 and the thickness t1 of the first partition 321 may be greater than or equal to the thickness t21 of the protrusion 340. For example, the difference value between the thickness t2 of the second-first partition 322_1 and the thickness t1 of the first partition 321 may be equal to the thickness t21 of the protrusion 340. For example, the difference value between the thickness t2 of the second-first partition 322_1 and the thickness t1 of the first partition 321 may be greater than the thickness t21 of the protrusion 340.

When the upper surface of each of the first partition 321, second-first partition 322_1 and second-second partition 322_2 is located on the horizontal plane, depending on whether the protrusion 340 is placed, the thickness t1, t2 and t3 of the first partition 321, second-first partition 322_1, and second-second partition 322_2 may be different. For example, by placing first assembly pattern 311, second assembly pattern 312, and protrusion 340 under first partition 321, the thickness t1 of the first partition 321 may be smaller than the thickness t2 of the second-first partition 322_1 or the thickness t3 of the second-second partition 322_2. For example, by placing first assembly wiring 313 and second assembly wiring 324 under second-first partition 322_1, the thickness t2 of the second-first partition 322_1 may be greater than the thickness t1 of the first partition 321 and may be smaller than the thickness t3 of the second-second partition 322_2. For example, because first assembly pattern 311, second assembly pattern 312, first assembly wiring 313, second assembly wiring 324 and/or protrusion 340 are not placed under second-second partition 322_2, the thickness t3 of the second-second partition 322_2 may be greater than the thickness t1 of the first partition 321 or the thickness t2 of the second-first partition 322_1.

For example, as shown in FIG. 14, dielectrophoretic force formed by the first assembly pattern 311 and the second assembly pattern 312 in the assembly area 310a is designed to affect the first partition 321, so the semiconductor light emitting device on the first partition 321 may be pulled into the assembly hole 325_R, 325_G and 325_B by the dielectrophoresis force and assembled in the assembly hole 325_R, 325_G and 325_B.

For example, since the thickness t2 of the second-first partition 322_1 is greater than the thickness t1 of the first partition 321, the dielectrophoretic force formed by the first assembly wiring 313 and the second assembly wiring 324 arranged in the non-assembly area 310b does not reach the second partition 322. Accordingly, the semiconductor light emitting device located on the second partition 322 is not fixed by the dielectrophoretic force and is therefore not attached to the upper surface of the second partition 322.

For example, not only is the thickness t3 of the second-second partition 322_2 greater than the thickness t1 of the first partition 321, but the first assembly pattern311, second assembly pattern 312, first assembly wiring313, and the second assembly wiring 324 is not arranged, so a dielectrophoretic force is not formed, therefore, a semiconductor light emitting device is not attached to the second-second partition 322_2.

Therefore, by using a part of the substrate 310 as the protrusion 340 so that the thickness t2 and t3 of the second partition 322 is greater than the thickness t1 of the first partition 321, it may have a following technical advantages.

Since the semiconductor light emitting device is not attached to the upper surface of the second partition 322, the flow of other semiconductor light emitting devices is not interrupted by the semiconductor light emitting device on the second partition 322, so other semiconductor light emitting devices may be assembled in the corresponding assembly hole, thereby improving the assembly rate.

In addition, since the semiconductor light emitting device is not attached to the upper surface of the second partition 322, the semiconductor light emitting device is not attached to the second partition 322 and discarded, thereby reducing material costs.

In addition, the semiconductor light emitting device is not attached to the upper surface of the second partition 322, so during the assembly process of other semiconductor light emitting devices, it is possible to prevent assembly errors in which a semiconductor light emitting device attached to the upper surface of the second partition 322 is assembled into an assembly hole where another semiconductor light emitting device is to be assembled.

In addition, since a semiconductor light emitting device is not attached to the upper surface of the second partition 322, connection defects such as disconnection of electrode wires may be prevented during the electrode wire connection process.

In addition, since the semiconductor light emitting device is not attached to the upper surface of the second partition 322, an additional process of removing the semiconductor light emitting device attached to the upper surface of the second partition 322 is not required, so the manufacturing process is simple and the manufacturing process time is shortened, which may improve productivity.

Meanwhile, although the drawing shows that the protrusion 340 is placed under the space between the first assembly pattern 311 and the second assembly pattern 312, the protrusion 340 may not be placed under the space between the first assembly pattern 311 and the second assembly pattern 312. That is, the protrusion 340 may include a first protrusion disposed below the first assembly pattern 311 and a second protrusion disposed below the second assembly pattern 312. At this time, the first protrusion and the second protrusion may be horizontally spaced apart from each other.

### [Third Embodiment]

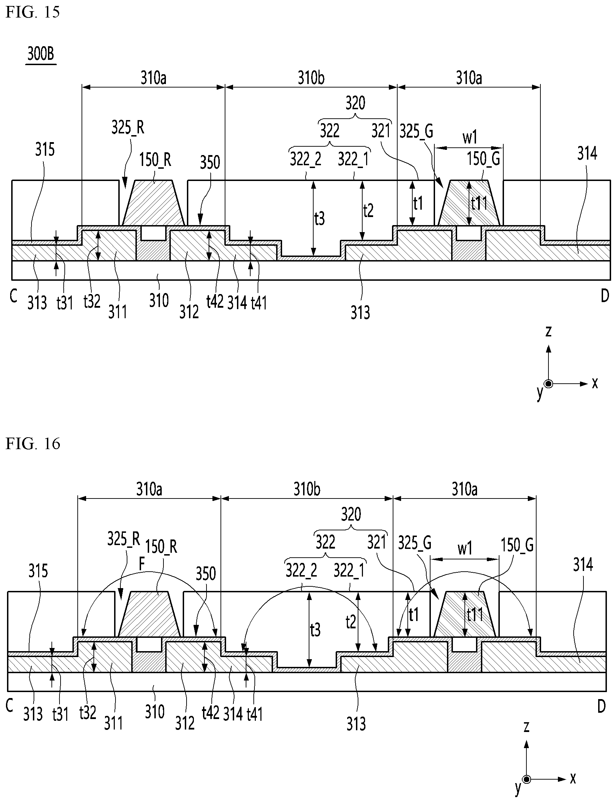

FIG. 15 is a cross-sectional view showing a display device according to a third embodiment.

The third embodiment is the same as the first embodiment except that the first assembly pattern 311 and the second assembly pattern 312 are used as protrusion 350. In the third embodiment, components having the same shape, structure, and/or function as those of the first or second embodiment are assigned the same reference numerals and detailed descriptions are omitted.

Referring to FIG. 15, the display device 300B according to the third embodiment may include a substrate310, protrusion 350, first assembly pattern311, second assembly pattern 312, partition321 and 322 and semiconductor light emitting device150_R, 150_G and 150_B. The display device 300B according to the third embodiment may include more components than these, but is not limited thereto.

The substrate 310 may have a plurality of assembly areas 310a and non-assembly areas 310b.

The protrusion 350 may be placed in each of the plurality of assembly areas 310a. The protrusion 350 may be the substrate 310, the first assembly pattern 311, and the second assembly pattern 312. For example, the first assembly pattern 311 may have a thickness t32 greater than the thickness t31 of the first assembly wiring 313. For example, the second assembly pattern 312 may have a thickness t42 greater than the thickness t41 of the second assembly wiring 324.

Therefore, the first assembly pattern 311 and the second assembly pattern 312 may be used as members that form a dielectrophoretic force to assemble the semiconductor light emitting device in the assembly hole 325_R, 325_G and 325_B. In addition, the first assembly pattern 311 and the second assembly pattern 312 may be used as protrusion 350 to vary the thickness t1 of the first partition 321 and the thickness t2 and t3 of the second partition 322. In this case, there is no need to provide a separate protrusion, which simplifies the structure and reduces costs.

By protrusion 350, the first assembly pattern 311 may be positioned higher than the first assembly wiring 313, and the second assembly pattern 312 may be positioned higher than the second assembly wiring 324.

The partition may be disposed on the first assembly pattern 311, second assembly pattern 312, first assembly wiring 313, second assembly wiring 324, and substrate 310.

The partition may have a first partition 321 and a second partition 322. The second partition 322 may have a second-first partition 322_1 and a second-second partition 322_2. The second-first partition 322_1 may be named the second partition 322, and the second-second partition 322_2 may be named the third partition.

An assembly hole 325_R, 325_G and 325_B is formed in the first partition 321 placed in the assembly area 310a, and a semiconductor light emitting device may be placed in the assembly hole 325_R, 325_G and 325_B.

For example, the first partition 321 may be placed in the assembly area 310a, and the second partition 322 may be placed in the non-assembly area 310b. For example, the first assembly pattern 311 and the second assembly pattern 312 may be placed under the first partition 321. For example, the first assembly wiring 313 and the second assembly wiring 324 may be placed under the second partition 322, especially the second-first partition 322_1.

The difference value between the thickness t2 and t3 of the second partition 322 and the thickness t1 of the first partition 321 may be more than the difference value between the thickness t31 of first assembly pattern 311 and the thickness t32 of first assembly wiring 313 or the difference value between the thickness t41 of the second assembly pattern 312 and the thickness t42 of the second assembly wiring 324

When the upper surface of each of the first partition 321, second-first partition 322_1 and second-second partition 322_2 is located on the horizontal plane, depending on whether the protrusion 350 is placed, the thickness t1, t2 and t3 of the first partition 321, second-first partition 322_1, and second-second partition 322_2 may be different. For example, since the first assembly pattern 311 and second assembly pattern 312, which are used as protrusion 350, are placed under the first partition 321, the thickness t1 of the first partition 321 may be smaller than the thickness t2 of the second-first partition 322_1 or the thickness t3 of the second-second partition 322_2. For example, since first assembly wiring 313 and second assembly wiring 324 are placed under second-first partition 322_1, the thickness t2 of the second-first partition 322_1 may be greater than the thickness t1 of the first partition 321 and may be smaller than the thickness t3 of the second-second partition 322_2. For example, since first assembly pattern 311, second assembly pattern 312, first assembly wiring 313, second assembly wiring 324 and/or protrusion 350 are not placed under second-second partition 322_2, the thickness t3 of the second-second partition 322_2 may be greater than the thickness t1 of the first partition 321 or the thickness t2 of the second-first partition 322_1.

For example, as shown in FIG. 16, it is designed so that the dielectrophoretic force formed by the first assembly pattern 311 and the second assembly pattern 312 in the assembly area 310a affects the first partition 321, and the semiconductor light emitting device on the first partition 321 is pulled into the assembly hole 325_R, 325_G and 325_B by the dielectrophoretic force and may be assembled in the assembly hole 325_R, 325_G and 325_B.

For example, since the thickness t2 of the second-first partition 322_1 is greater than the thickness t1 of the first partition 321, the dielectrophoretic force formed by the first assembly wiring 313 and the second assembly wiring 324 arranged in the non-assembly area 310b does not reach the second partition 322. Accordingly, the semiconductor light emitting device located on the second partition 322 is not fixed by the dielectrophoretic force and is therefore not attached to the upper surface of the second partition 322.

For example, not only is the thickness t3 of the second-second partition 322_2 greater than the thickness t1 of the first partition 321, but also the first assembly pattern 311, the second assembly pattern 312, the first assembly wiring313 and the second assembly wiring 324 are not arranged, so dielectrophoresis force is not formed, therefore, the semiconductor light emitting device is not attached to the second-second partition 322_2.

Therefore, by using the first assembly pattern 311 and the second assembly pattern 312 as the protrusion 350, the thickness t2 and t3 of the second partition 322 is greater than the thickness t1 of the first partition 321, it may have a following technical advantages.

Since the semiconductor light emitting device is not attached to the upper surface of the second partition 322, the flow of other semiconductor light emitting devices is not interrupted by the semiconductor light emitting device on the second partition 322, so other semiconductor light emitting devices may be assembled in the corresponding assembly hole, thereby improving the assembly rate.

In addition, since the semiconductor light emitting device is not attached to the upper surface of the second partition 322, the semiconductor light emitting device is not attached to the second partition 322 and discarded, thereby reducing material costs.

In addition, the semiconductor light emitting device is not attached to the upper surface of the second partition 322, so during the assembly process of other semiconductor light emitting devices, it is possible to prevent assembly errors in which a semiconductor light emitting device attached to the upper surface of the second partition 322 is assembled into an assembly hole where another semiconductor light emitting device is to be assembled.

In addition, since a semiconductor light emitting device is not attached to the upper surface of the second partition 322, connection defects such as disconnection of electrode wires may be prevented during the electrode wire connection process.

Additionally, since the semiconductor light emitting device is not attached to the upper surface of the second partition 322, there is no need for an additional process to remove the semiconductor light emitting device attached to the upper surface of the second partition 322, so the manufacturing process is simple and the manufacturing process time is shortened, which may improve productivity.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### Industrial Applicability

The embodiment may be adopted in the field of displays that display images or information.

The embodiment may be adopted in the field of displays that display images or information using a semiconductor light emitting device. The semiconductor light emitting device may be a micro-level semiconductor light emitting device or a nano-level semiconductor light emitting device.

## Claims

1. A display device comprising:
a substrate having a plurality of assembly areas and non-assembly areas;
a first partition disposed on the plurality of the assembly areas and having an assembly hole;
a second partition disposed on the non-assembly areas; and
a semiconductor light emitting device in the assembly hole,
wherein a thickness of the second partition is greater than a thickness of the first partition.

2. The display device according to claim 1, further comprising a protrusion disposed in the plurality of the assembly areas.

3. The display device according to claim 2, wherein the protrusion is a pattern spaced apart from each other.

4. The display device according to claim 2, wherein a difference value between the thickness of the second partition and the thickness of the first partition is greater than or equal to a thickness of the protrusion.

5. The display device according to claim 2, wherein the protrusion is an insulating member.

6. The display device according to claim 5, wherein the insulating member is disposed between the substrate and the first partition.

7. The display device according to claim 2, wherein the protrusion is a part of the substrate.

8. The display device according to claim 2, further comprising:
a first assembly pattern on the substrate;
a first assembly wiring connected to the first assembly pattern and disposed along a first direction;
a second assembly pattern facing the first assembly pattern along a second direction on the substrate; and
a second assembly wiring connected to the second assembly pattern and disposed along the first direction.

9. The display device according to claim 8, wherein the semiconductor light emitting device includes a plurality of semiconductor light emitting devices disposed in the plurality of the assembly holes between the first assembly wiring and the second assembly wiring along the first direction, and
wherein the protrusion is disposed below each of the plurality of the semiconductor light emitting devices.

10. The display device according to claim 8, wherein the plurality of the semiconductor light emitting devices emit a same color light.

11. The display device according to claim 8, wherein the second partition comprises:
a second-first partition on the first assembly wiring and the second assembly wiring; and
a second-second partition disposed on the substrate.

12. The display device according to claim 11, wherein a thickness of the second-first partition is greater than a thickness of the first partition.

13. The display device according to claim 11, wherein a thickness of the second-second partition is greater than a thickness of the second-first partition.

14. The display device according to claim 11, wherein the protrusion is the first assembly pattern and the second assembly pattern.

15. The display device according to claim 14, wherein the first assembly pattern has a thickness greater than a thickness of the first assembly wiring,
wherein the second assembly pattern has a thickness greater than a thickness of the second assembly wiring.

16. The display device according to claim 11, wherein an upper surface of each of the first partition, the second-first partition, and the second-second partition is located on the same plane,
wherein a lower surface of each of the first partition, the second-first partition, and the second-second partition is not located on the same plane.

17. The display device according to claim 16, wherein the lower surface of the second-first partition is configured to protrudes downward from the lower surface of the first partition.

18. The display device according to claim 17, wherein the lower surface of the second-second partition is configured to protrude downward from the lower surface of the second-first partition.

19. The display device according to claim 2, wherein a width of the protrusion is greater than a width of the assembly hole.
